# EUROPEAN PATENT APPLICATION

(11) **EP 3 930 004 A1**
(43) Date of publication of application: **29.12.2021**
(21) Application number: 20214380.6
(22) Date of filing: 15.12.2020
(51) Int. Cl.: H01L 29/775, H01L 21/336, H01L 29/06, H01L 29/10, H01L 29/08, H01L 29/423, B82Y 10/00, H01L 27/092, H01L 29/78

(54) **GATE-ALL-AROUND INTEGRATED CIRCUIT STRUCTURES HAVING STRAINED SOURCE OR DRAIN STRUCTURES ON GATE DIELECTRIC LAYER**

(30) Priority: 25.06.2020 US 202016912136
(71) Applicant: INTEL Corporation, Santa Clara, CA 95054 (US)
(72) Inventor: KAVALIEROS, Jack T., Portland, OR Oregon 97229 (US); MURTHY, Anand S., Portland, OR Oregon 97229 (US); RACHMADY, Willy, Beaverton, OR Oregon 97007 (US); AGRAWAL, Ashish, Hillsboro, OR Oregon 97124 (US); CHOUKSEY, Siddharth, Portland, OR, OR Oregon 97229 (US); KEECH, Ryan, Portland, OR Oregon 97209 (US); GANGULY, Koustav, Beaverton, OR Oregon 97006 (US)
(74) Representative: 2SPL Patentanwälte PartG mbB

(57) **Abstract**

Gate-all-around integrated circuit structures having strained source or drain structures on a gate dielectric layer, and methods of fabricating gate-all-around integrated circuit structures having strained source or drain structures on a gate dielectric layer, are described. For example, an integrated circuit structure includes an insulator layer above a substrate. A vertical arrangement of horizontal semiconductor nanowires is over the insulator layer. A pair of epitaxial source or drain structures is at first and second ends of the vertical arrangement of horizontal semiconductor nanowires and on the insulator layer. A gate stack is surrounding a channel region of the vertical arrangement of horizontal semiconductor nanowires. The gate stack includes a high-k dielectric layer continuous with and having a same composition as the insulator layer.

## Description

### TECHNICAL FIELD

Embodiments of the disclosure are in the field of integrated circuit structures and processing and, in particular, gate-all-around integrated circuit structures having strained source or drain structures on gate dielectric layer, and methods of fabricating gate-all-around integrated circuit structures having strained source or drain structures on a gate dielectric layer.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

In the manufacture of integrated circuit devices, multi-gate transistors, such as tri-gate transistors, have become more prevalent as device dimensions continue to scale down. In conventional processes, tri-gate transistors are generally fabricated on either bulk silicon substrates or silicon-on-insulator substrates. In some instances, bulk silicon substrates are preferred due to their lower cost and because they enable a less complicated tri-gate fabrication process. In another aspect, maintaining mobility improvement and short channel control as microelectronic device dimensions scale below the 10 nanometer (nm) node provides a challenge in device fabrication. Nanowires used to fabricate devices provide improved short channel control.

Scaling multi-gate and nanowire transistors has not been without consequence, however. As the dimensions of these fundamental building blocks of microelectronic circuitry are reduced and as the sheer number of fundamental building blocks fabricated in a given region is increased, the constraints on the lithographic processes used to pattern these building blocks have become overwhelming. In particular, there may be a trade-off between the smallest dimension of a feature patterned in a semiconductor stack (the critical dimension) and the spacing between such features.

### BRIEF DESCRIPTION OF THE DRAWINGS

Figure 1A illustrates a cross-sectional view of a gate-all-around integrated circuit structure on an insulator substrate.
Figure 1B illustrates a cross-sectional view of a gate-all-around integrated circuit structure on a semiconductor substrate.
Figure 1C illustrates a cross-sectional view of a gate-all-around integrated circuit structure on a semiconductor body on an insulator substrate.
Figures 2A-2D illustrate cross-sectional views representing various operations in a method of fabricating a gate-all-around integrated circuit structure having strained source or drain structures on a gate dielectric layer, in accordance with an embodiment of the present disclosure.
Figure 3 illustrates a cross-sectional view of a gate-all-around integrated circuit structure having strained source or drain structures on a gate dielectric layer, in accordance with an embodiment of the present disclosure.
Figure 4A and 4B illustrate a gate cut cross-sectional view and a fin cut cross-sectional view, respectively, of a gate-all-around integrated circuit structure having strained source or drain structures on a gate dielectric layer, in accordance with an embodiment of the present disclosure.
Figure 5 illustrates a cross-sectional view of another gate-all-around integrated circuit structure having strained source or drain structures on a gate dielectric layer, in accordance with another embodiment of the present disclosure.
Figure 6 illustrates a cross-sectional views of a non-planar integrated circuit structure as taken along a gate line, in accordance with an embodiment of the present disclosure.
Figure 7 illustrates cross-sectional views taken through nanowires and fins for a non-endcap architecture (left-hand side (a)) versus a self-aligned gate endcap (SAGE) architecture (right-hand side (b)), in accordance with an embodiment of the present disclosure.
Figure 8A illustrates a three-dimensional cross-sectional view of a nanowire-based integrated circuit structure, in accordance with an embodiment of the present disclosure.
Figure 8B illustrates a cross-sectional source or drain view of the nanowire-based integrated circuit structure of Figure 8A, as taken along the a-a' axis, in accordance with an embodiment of the present disclosure.
Figure 8C illustrates a cross-sectional channel view of the nanowire-based integrated circuit structure of Figure 8A, as taken along the b-b' axis, in accordance with an embodiment of the present disclosure.
Figure 9 illustrates a computing device in accordance with one implementation of an embodiment of the disclosure.
Figure 10 illustrates an interposer that includes one or more embodiments of the disclosure.

### DESCRIPTION OF THE EMBODIMENTS

Gate-all-around integrated circuit structures having strained source or drain structures on a gate dielectric layer, and methods of fabricating gate-all-around integrated circuit structures having strained source or drain structures on a gate dielectric layer, are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments described herein are directed to nanowire (NW) or nanoribbon (NR) devices including ultrathin etch stop layers for isolation of strained nanowire CMOS devices. Embodiments may be directed to isolation schemes for nanowire (NW) and/or nanoribbon (NR) transistors using high-k gate dielectric layers, with strain source or drain structures on a high-k gate dielectric layer. Embodiments may be implemented to provide a nanowire/nanoribbon transistor having reduced leakage while maintaining strain in epitaxial source or drain structures. Embodiments with reference to a nanowire may encompass wires nanowires sized as wires or ribbons or sheets, unless specifically stated for nanowire-only dimensions.

To provide context, in state of the art gate-all-around (GAA) technology, the source/drain (S/D) junction can connect to substrate leading to an undesired high leaking path. State-of-the-art solutions for blocking or inhibiting source to drain leakage through semiconductor structures (such as sub-fin structures) beneath a nanowire device include sub-fin doping and/or physically increasing a gap between nanowires/nanoribbons and the underlying substrate structure. Both approaches, however, are associated with added process complexity.

To provide further context, nanoribbon, nanowire and nanosheet architectures require that the source, drain and gate be isolated from a sub-fin layer to reduce parallel conduction between source to drain and large parasitic capacitance from the gate to the sub-fin. Isolating a source or drain epitaxial structure from the substrate can result in loss of compressive strain in the channel and significant degradation in PMOS performance. Embodiments described herein can be implemented to isolate an active transistor from a sub-fin during a replacement metal gate (RMG) operation. Such an approach enables an epitaxial source or drain structure to grow pseudomorphic to an underlying substrate and to impart strain to the nanowire/nanosheet channel which can be essential for high performance. In one or more embodiments, isolating the sub-fin at RMG can maintain a strain in the source, drain and channel.

Previous approaches to maintaining strain in source or drain structures have included depositing strain liners in a trench contact (TCN) opening in order to impart strain from a source or drain side. However, very small TCN openings in scaled technology nodes can result in a small volume of liners and thus not produce sufficient substantial strain in the channel. Another approach has involved relying on an associated metal gate to impart strain in the channel. However, a relatively small gate volume can prevent significant strain from the metal gate. Additionally, different metal gates are typically used for NMOS and PMOS transistors as they require different work-functions and opposite types of strain.

In accordance with one or more embodiments of the present disclosure, epitaxial source or drain structures are grown pseudomorphic from an underlying substrate in order to strain an adjacent channel. During a replacement gate process, an ultrathin, pseudomorphic etch stop layer is selectively etched away in the gate and underneath the source or drain region which creates a gap between source and drain and the substrate. In a subsequent operation, a high-k dielectric layer is deposited and fills in the gap, successfully disconnecting the source or drain structures from the substrate. The resulting isolated yet strained epitaxial source or drain structures can impart desired strain to the nanowire or nanoribbon or nanosheet channel. Additionally, in an embodiment, the strained epitaxial source or drain structures can have a bottom surface directly on the gate dielectric layer in order to reduce source to drain leakage.

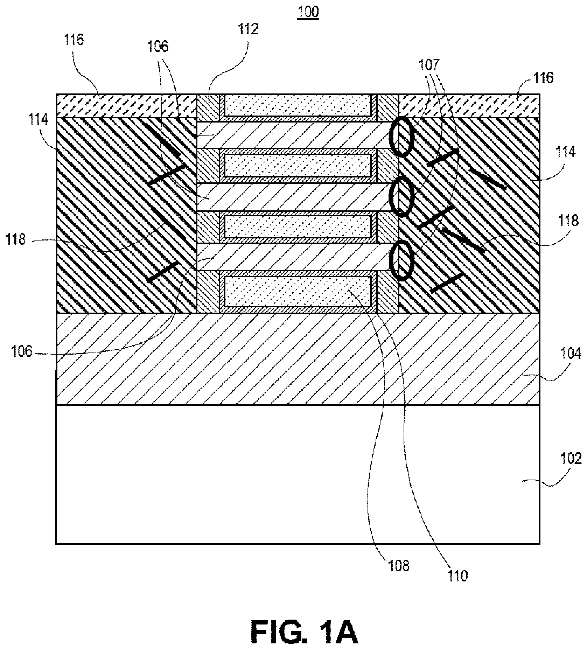

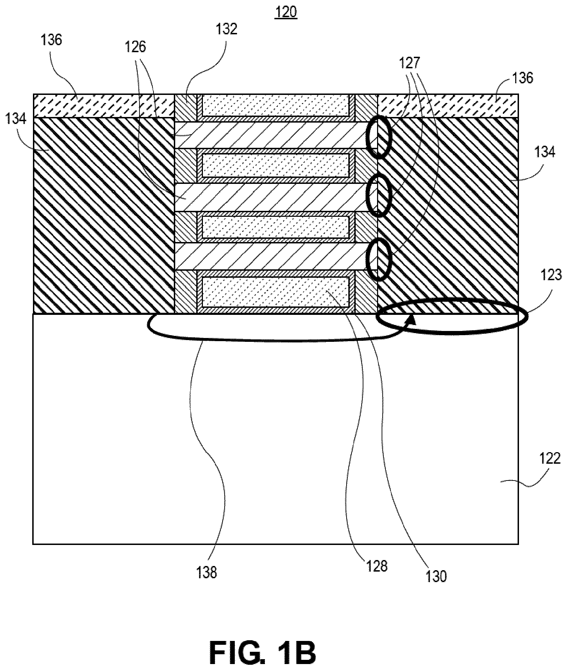

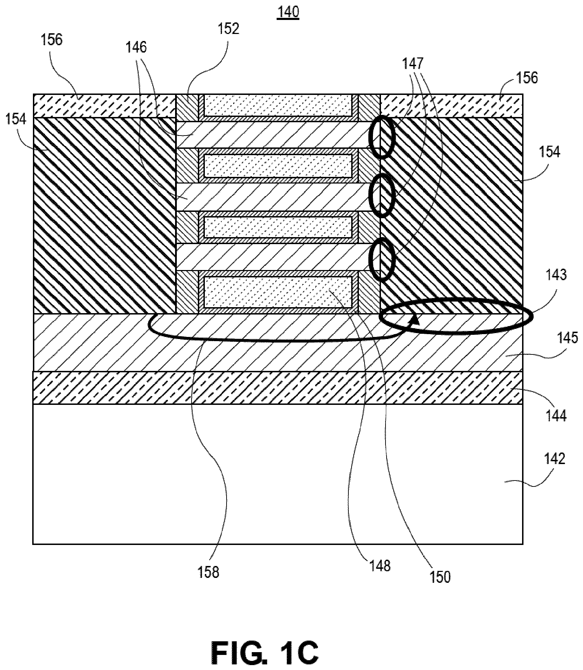

To provide yet further context, there are several integration approaches for forming NW/NR devices: (1) forming a NW/NR device on an SOI or layer transferred bulk substrate with an epitaxial region seeded laterally from channel stubs (e.g., as described below in association with Figure 1A), and (2) forming a NW/NR device on a bulk or SOI substrate with an epitaxial region seeded from the substrate beneath and from channel stubs (e.g., as described below in association with Figure 1B for a bulk substrate, and in association with Figure 1C for an SOI or XOI substrate).

As a comparative example, Figure 1A illustrates a cross-sectional view of a gate-all-around integrated circuit structure on an insulator substrate.

Referring to Figure 1A, an integrated circuit structure 100 is on an insulator substrate 104/102, such as a substrate having an insulator layer 104 (such as silicon oxide) on a bulk semiconductor material 102 (such as crystalline silicon). A vertical arrangement of horizontal semiconductor nanowires 106 is over the insulator substrate 104/102. A gate stack surrounds a channel region of the vertical arrangement of horizontal semiconductor nanowires 106, the gate stack including a gate electrode 108 and a gate dielectric 110. The gate stack is on the insulator layer 104 of the insulator substrate 104/102. A gate spacer 112 is on either side of the gate stack. A pair of epitaxial source or drain structures 114 is at first and second ends of the vertical arrangement of horizontal semiconductor nanowires 106 and on the insulator layer 104 of the insulator substrate 104/102. Source or drain contacts 116 are on the pair of epitaxial source or drain structures 114. In one embodiment, the pair of epitaxial source or drain structures 114 includes defects 118.

Referring again to Figure 1A, a NW/NR device can be fabricated with source/drain (S/D) epitaxial material (epi) seeded laterally from channel stubs (within circled regions 107). Seeding epi in this manner has been shown to produce defected/low-quality epi in the S/D. For simplicity, the epi shape in the S/D is shown generically, but it may be faceted/incompletely filled or voided/etc. Forming the device on an SOI substrate does, however, eliminate the need for a sub-fin doping solution to eliminate leakage current and to provide for CMOS isolation. Although, the poor quality epi grown in this and similar devices may not produce high channel stress needed for optimal device performance.

As another comparative example, Figure 1B illustrates a cross-sectional view of a gate-all-around integrated circuit structure on a semiconductor substrate.

Referring to Figure 1B, an integrated circuit structure 120 is on a bulk semiconductor substrate 122 (such as a bulk crystalline silicon substrate). A vertical arrangement of horizontal semiconductor nanowires 126 is over the bulk semiconductor substrate 122. A gate stack surrounds a channel region of the vertical arrangement of horizontal semiconductor nanowires 126, the gate stack including a gate electrode 128 and a gate dielectric 130. The gate stack is on the bulk semiconductor substrate 122. A gate spacer 132 is on either side of the gate stack. A pair of epitaxial source or drain structures 134 is at first and second ends of the vertical arrangement of horizontal semiconductor nanowires 126 and on the bulk semiconductor substrate 122. Source or drain contacts 136 are on the pair of epitaxial source or drain structures 134.

Referring again to Figure 1B, a NW/NR structure formed on a bulk substrate with S/D epi seeded largely from the horizontal exposed substrate 123 and less so from the channel stubs 127. This configuration of epi growth has been shown experimentally to produce a much higher-quality/less-defected epi region than the structure shown in Figure 1A. The structure of Figure 1B may, however, require a sub-fin isolation doping scheme to eliminate the sub-fin leakage paths (such as 138) and provide for CMOS isolation.

As another comparative example, Figure 1C illustrates a cross-sectional view of a gate-all-around integrated circuit structure on a semiconductor body on an insulator substrate.

Referring to Figure 1C, an integrated circuit structure 140 is on a semiconductor body 145 (such as a silicon body) on a buried oxide layer 144 (such as a silicon oxide layer) on a bulk semiconductor material 142 (such as crystalline silicon). A vertical arrangement of horizontal semiconductor nanowires 146 is over the semiconductor body 145. A gate stack surrounds a channel region of the vertical arrangement of horizontal semiconductor nanowires 146, the gate stack including a gate electrode 148 and a gate dielectric 150. The gate stack is on the semiconductor body 145. A gate spacer 152 is on either side of the gate stack. A pair of epitaxial source or drain structures 154 is at first and second ends of the vertical arrangement of horizontal semiconductor nanowires 146 and on the semiconductor body 145. Source or drain contacts 156 are on the pair of epitaxial source or drain structures 154.

Referring again to Figure 1C, similar structure to that of the structure of Figure 1B, a state-of-the-art NW/NR device is fabricated on a SOI or XOI substrate with bottom-seeded epi (e.g., seeded largely from or entirely from the horizontal exposed substrate 143 and less so or not at all from the channel stubs 147). This structure also may require a sub-fin doping scheme to prevent leakage current (pathway 158) and provide for CMOS isolation.

Disadvantages of the structures of Figures 1A-1C include the tradeoff between channel strain and a need for a complicated sub-fin isolation solution. In many regards, a sub-fin isolation doping scheme for a NW/NR device is more complicated than that required for a finfet. Specifically, all of the NWs/NRs in same device may need to have the same nominal doping (and ideally be undoped for optimal mobility) so as to have the same electrostatics (i.e., one wire should not conduct before or after the other wires, and the Vt should be the same).

Providing further context, to prevent sub-fin conduction, doping of approximately 3E18/cm³ may be required beneath the gate in the substrate (bulk device) or body region (XOI device). To provide for highest mobility, the lowest NW/NR may be undoped (or effectively less than about 3E16/cm³). Such a doping gradient cannot be easily realized for a wide ribbon/wire via implant alone for greater than two wires spaced at about 10nm apart. Rather, a complicated implant/dose-loss process may be required which will likely result in less optimal performance of the lower-most NW/NR Embodiments described herein eliminate the need for such a complicated integration process and provides for high-quality epitaxial S/D growth.

In contrast to the approaches described in association with Figures 1A-1C, embodiments described herein can be implemented to provide a device structure that maintains strain in epitaxial source or drain structures for nanowire or nanoribbon or nanosheet architectures, enabling high performance along with superior electrostatics. In an embodiment, sub-fin isolation is achieved which prevents parasitic off-state leakage and parasitic capacitance.

Embodiments of the present disclosure can be implemented to obtain high performance nanowire or nanoribbon or nanosheet transistors with minimal parasitic leakage and capacitance. In some embodiments, an ultrathin, pseudomorphic strained etch stop layer is introduced between a sub-fin and active nanowire or nanoribbon or nanosheet layers. Embodiments described below may use the context of Si and SiGe material regimes, however, it is to be appreciated that embodiments described herein can be applied to any pseudomorphic heterostructure material system.

It is to be appreciated that, regarding detectability in a final product, transmission electron microscopy (TEM) and scanning electron microscopy (SEM) cross-section analysis can reveal isolated active devices, e.g., with a high-k layer in an isolation region, while XRD and Raman spectroscopy can show evidence of strain in channel even after isolation.

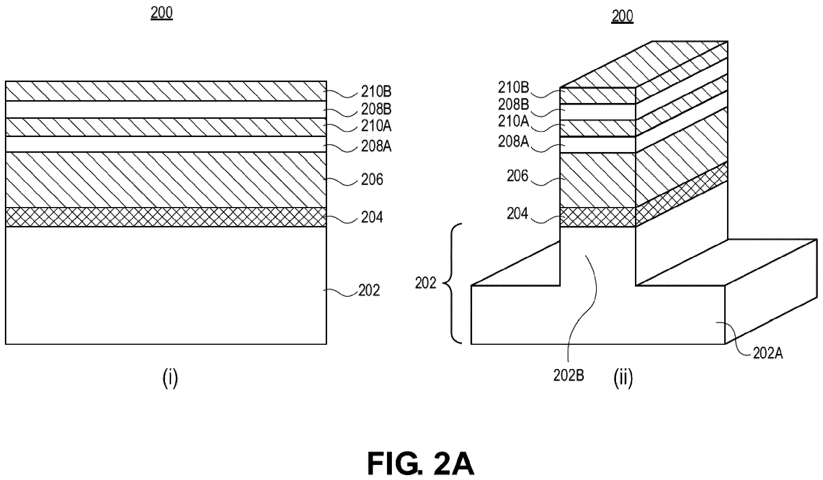

In an exemplary processing scheme, Figures 2A-2D illustrate cross-sectional views representing various operations in a method of fabricating a gate-all-around integrated circuit structure having strained source or drain structures on a gate dielectric layer, in accordance with an embodiment of the present disclosure.

Referring to Figure 2A, a starting structure 200 is shown as a flat cross-sectional view (i) and an angled cross-sectional view (ii). The starting structure 200 includes a substrate 202, such as a silicon substrate 202. A pseudomorphic etch stop layer 204 is on the substrate 202. A first channel release layer 206, such as a silicon germanium layer, is on the pseudomorphic etch stop layer 204. Nanowire (or nanoribbon or nanosheet) layers 208A and 208B, such as silicon layers, alternate with additional channel release layers 210A and 210B, such as additional silicon germanium layers. The nanowire (or nanoribbon or nanosheet) layers 208A and 208B, the additional channel release layers 210A and 210B, the first channel release layer 206, the pseudomorphic etch stop layer 204, and an upper portion 202B of the substrate 202 form a fin above a lower portion 202A of the substrate 202.

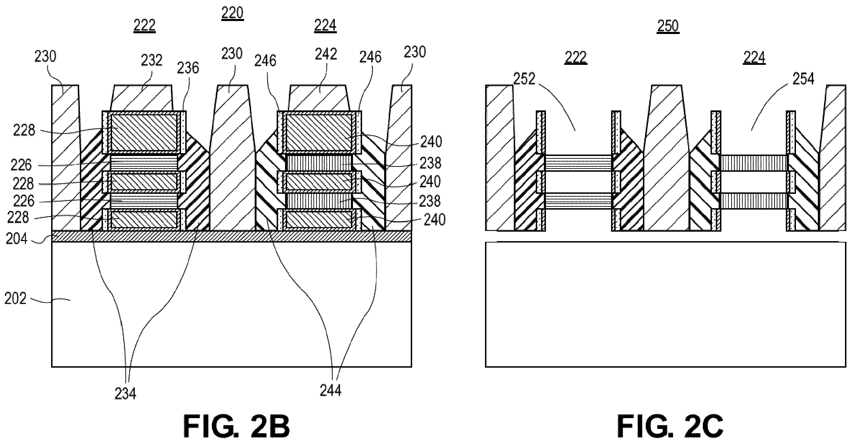

Following the formation of structure 200 from Figure 2A, subsequent processing can include selective release of the nanowire (or nanoribbon or nanosheet) layers 208A and 208B, formation of a dummy gate stack by use of any one of possible suitable processing schemes, and growth of source or drain epitaxial structures pseudomorphic to the substrate along with active area definition. In an example, referring to Figure 2B, an intermediate structure 220 includes dielectric structures 230, such as ILD layers and/or gate endcap walls, above the pseudomorphic etch stop layer 204.

An NMOS region 222 includes nanowires 226 (or nanoribbons or nanosheets) over the pseudomorphic etch stop layer 204. A dummy N-type gate stack 228 (which can include a dummy gate dielectric and dummy gate electrode) surrounds the nanowires 226 and is on the pseudomorphic etch stop layer 204. A cap layer 232 may be on the dummy N-type gate stack 228, as is depicted. N-type (e.g., N+) source or drain structures 234 are at ends of the nanowires 226 and are on the pseudomorphic etch stop layer 204.

A PMOS region 224 includes nanowires 238 (or nanoribbons or nanosheets) over the pseudomorphic etch stop layer 204. A dummy P-type gate stack 240 (which can include a dummy gate dielectric and dummy gate electrode) surrounds the nanowires 238 and is on the pseudomorphic etch stop layer 204. A cap layer 242 may be on the dummy P-type gate stack 240, as is depicted. P-type (e.g., P+) source or drain structures 244 are at ends of the nanowires 238 and are on the pseudomorphic etch stop layer 204.

In an embodiment, the N-type source or drain structures 234 and the P-type source or drain structures 244 are epitaxial structures. Since the epitaxial structures are grown connected to the pseudomorphic etch stop layer 204 (which mimics the lattice constant of the substrate 202), the resulting N-type source or drain structures 234 and/or P-type source or drain structures 244 can provide strain to the corresponding nanowires 226 or 238. In one such embodiment, due to a difference in lattice constant between the pseudomorphically grown source or drain structures 234 or 244 and the channel (e.g., nanowires, nanoribbons or nanosheets), the channel is consequently strained dependent on the lattice mismatch.

Referring to Figure 2C, a structure 250 is shown following removal of the dummy gate dielectric and dummy gate electrode of the dummy N-type gate stack 228, removal of the dummy gate dielectric and dummy gate electrode of the dummy P-type gate stack 240, and removal of the pseudomorphic etch stop layer 204 to form cavities 252 and 254. The pseudomorphic etch stop layer 204 is exposed following removal of the dummy N-type gate stack 228 and the dummy P-type gate stack 240. Removal of the pseudomorphic etch stop layer 204 creates an opening underneath the pseudomorphically grown source or drain structures 234 or 244.

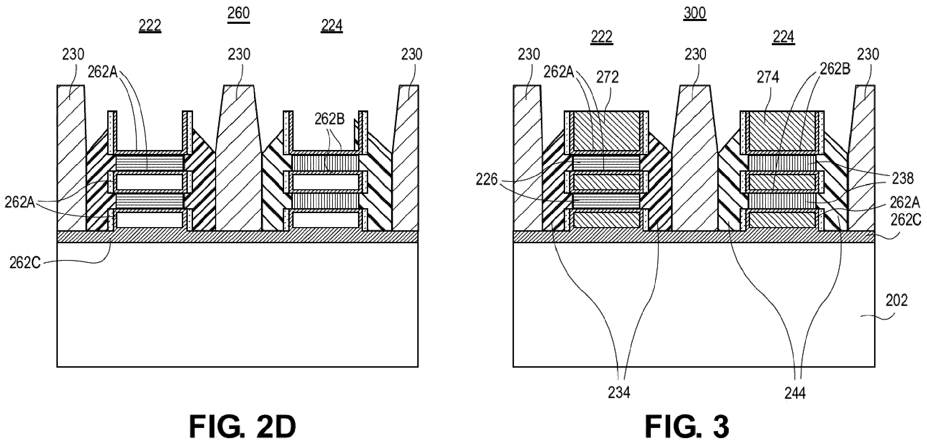

Referring to Figure 2D, a high-k dielectric material is formed in the cavities 252 and 254 of the structure 250 of Figure 2C to form structure 260. The high-k dielectric material includes a gate dielectric portion 262A in the NMOS region 222, a gate dielectric portion 262B in the NMOS region 224, and a leakage blocking portion 262C. It is to be appreciated that, in one embodiment, the leakage blocking portion 262C completely fills the portion of the cavities 252 and 254 beneath the pseudomorphically grown source or drain structures 234 or 244 such that later formed metal gate material does not form in those locations.

Subsequent processing can include permanent gate formation. As an example, Figure 3 illustrates a cross-sectional view of a gate-all-around integrated circuit structure 300 having strained source or drain structures on a gate dielectric layer, in accordance with an embodiment of the present disclosure. An N-type metal gate electrode 272 is formed in the NMOS region 222, and a P-type metal gate electrode 274 is formed in the PMOS region 224. In an embodiment, not shown, a source or drain metal contact deposition can also be implemented to form a conductive source or drain contact directly on the pair of epitaxial source or drain structures 234 or 244.

With reference again to Figure 3, in accordance with an embodiment of the present disclosure, an integrated circuit structure 300 includes an insulator layer 262C above a substrate 202. A vertical arrangement of horizontal semiconductor nanowires 226 or 238 is over the insulator layer 262C. A pair of epitaxial source or drain structures 234 or 244 is at first and second ends of the vertical arrangement of horizontal semiconductor nanowires 226 or 238 and on the insulator layer 262C. A gate stack is surrounding a channel region of the vertical arrangement of horizontal semiconductor nanowires 226 or 238. In an embodiment, the gate stack includes a high-k dielectric layer 262A or 262B continuous with and having a same composition as the insulator layer 262C.

In an embodiment, said another way, the gate stack includes a high-k dielectric layer 262A/262C or 262B/262C having a lowermost portion 262C extending laterally beyond first and second ends of the vertical arrangement of horizontal semiconductor nanowires 226 or 238. A pair of epitaxial source or drain structures 234 or 244 is at the first and second ends of the vertical arrangement of horizontal semiconductor nanowires 226 or 238 and on the lowermost portion of the high-k dielectric layer 262C of the gate stack.

In an embodiment, the high-k material 262A/262B/262C is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. In an embodiment, the insulator layer 262C is on a sub-fin (e.g., 202B of Figure 2A), the sub-fin above or on the substrate (e.g., 202A of Figure 2). In an embodiment, the vertical arrangement of horizontal semiconductor nanowires 226 or 238 includes silicon. In an embodiment, the pair of epitaxial source or drain structures 234 or 244 is a pair of non-discrete epitaxial source or drain structures, as is depicted in Figure 3.

In an embodiment, the gate stack includes a metal gate electrode 272 or 274. In an embodiment, the semiconductor material of the pair of epitaxial source or drain structures 234 is silicon. In an example, the semiconductor material of the pair of epitaxial source or drain structures 244 is silicon germanium.

With reference again to Figure 3, in an embodiment, one or both of the pair of epitaxial source or drain structures 234 or 244 has a compressed lattice and, as such, is a compressively strained pair of epitaxial source or drain structures 234 or 244. The compressed lattice has a smaller lattice constant that the lattice constant of a relaxed form of the same semiconductor material. In another embodiment, one or both of the pair of epitaxial source or drain structures 234 or 244 has an expanded lattice and, as such, is a tensilely strained pair of epitaxial source or drain structures 234 or 244. The expanded lattice has a larger lattice constant that the lattice constant of a relaxed form of the same semiconductor material.

It is to be appreciated that a compressively strained or a tensilely strained pair of epitaxial source or drain structures 234 or 244 can impart a strain to an adjacent set of nanowires, nanoribbons or nanosheets and, hence, can may be a strain-inducing source or drain structures. For example, in one embodiment, a strain-inducing pair of epitaxial source or drain structures 234 or 244 can impart a uniaxial tensile strain. In this case, the lattice-forming atoms of the strain-inducing source/drain region are effectively pulled apart (i.e., tensile strain) from their normal resting state and hence may induce a tensile strain on the adjacent set of nanowires, nanoribbons or nanosheets as they attempt to relax. In another example, in one embodiment, a strain-inducing pair of epitaxial source or drain structures 234 or 244 can impart a uniaxial compressive strain. In this case, the lattice-forming atoms of the strain-inducing source/drain region are effectively pushed together (i.e., compressive strain) from their normal resting state and hence may induce a compressive strain on the adjacent set of nanowires, nanoribbons or nanosheets as they attempt to relax. Therefore, either a compressive or tensile uniaxial strain may be imparted to an adjacent set of nanowires, nanoribbons or nanosheets by a strained semiconductor structure.

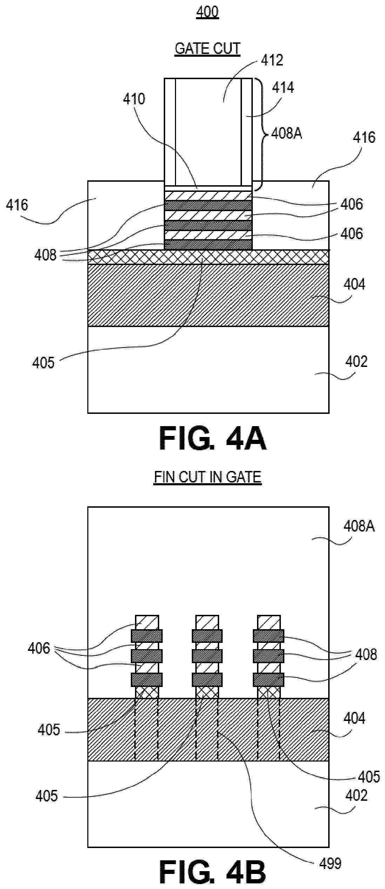

As another exemplary device, Figure 4A and 4B illustrate a gate cut cross-sectional view and a fin cut cross-sectional view, respectively, of a gate-all-around integrated circuit structure having strained source or drain structures on a gate dielectric layer, in accordance with an embodiment of the present disclosure.

Referring to Figures 4A and 4B, an integrated circuit structure 400 includes an insulator layer 405 on an optional buffer layer 404 on a substrate 402, such as a semiconductor buffer layer 404 on a bulk semiconductor material 402 (such as crystalline silicon). A vertical arrangement of horizontal semiconductor nanowires 406 is over the insulator layer 405. A gate stack 408/408A surrounds a channel region of the vertical arrangement of horizontal semiconductor nanowires 406. The gate stack 408/408A is also overlying the insulator layer 405 (e.g., is along a top and, possibly, along the sides of the insulator layer 405). Gate spacers 414 may also be included. A pair of epitaxial source or drain structures 416 is at first and second ends of the vertical arrangement of horizontal semiconductor nanowires 406 and on the insulator layer 405. In one embodiment, the insulator layer 405 is a portion of a fin that includes optional buffer layer 404, as indicated by dashed line 499, and may even include a portion of the substrate 402. In accordance with an embodiment of the present disclosure, the gate stack 408/408A includes a high-k dielectric layer continuous with and having a same composition as the insulator layer 405, such as described in association with Figure 3.

In an embodiment, the vertical arrangement of horizontal semiconductor nanowires 406 includes silicon. In another embodiment, the vertical arrangement of horizontal semiconductor nanowires 406 includes silicon germanium. In another embodiment, the vertical arrangement of horizontal semiconductor nanowires 406 includes a group III-V material.

In an embodiment, a bottom of the pair of epitaxial source or drain structures 416 is directly on the insulator layer 405, as is depicted. In an embodiment, the pair of epitaxial source or drain structures 416 is a pair of non-discrete epitaxial source or drain structures, as is depicted, and as is described in greater detail below.

For clarity of illustration, gate stacks 408 and 408A are depicted as separate structures. However, in an embodiment, the regions 408 and 408A are continuous structures. In one such embodiment, the gate stack 408A includes a gate electrode 412 and a gate dielectric 410 (while 408 represents an gate electrode and gate dielectric as one). It is to be appreciated that both the gate electrode 412 and a gate dielectric 410 may be continuous around and between the vertical arrangement of horizontal semiconductor nanowires 406.

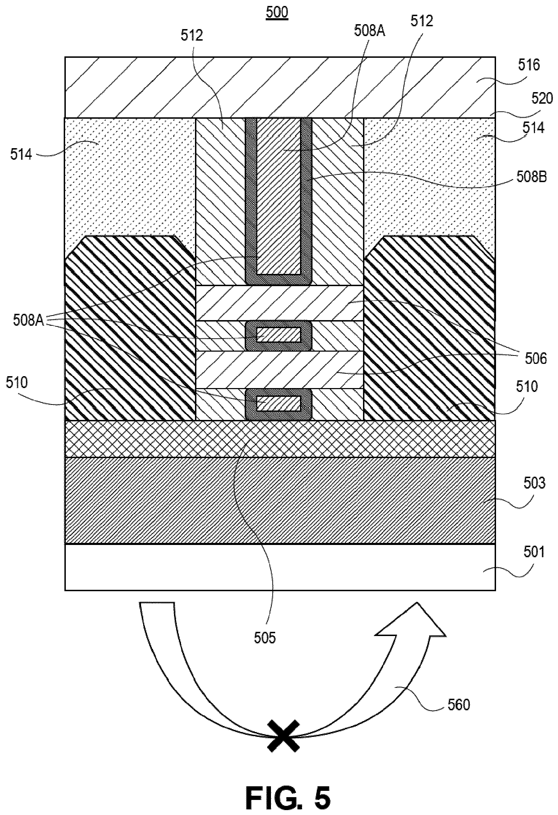

As another exemplary device, Figure 5 illustrates a cross-sectional view of another gate-all-around integrated circuit structure having strained source or drain structures on a gate dielectric layer, in accordance with another embodiment of the present disclosure.

Referring to Figure 5, an integrated circuit structure 500 includes a vertical arrangement of horizontal semiconductor nanowires 506 above an insulator layer 505 above an optional buffer layer 503 above a substrate 501. A gate stack 508A/508B (with gate electrode 508A and gate dielectric 508B) surrounds a channel region of the vertical arrangement of horizontal semiconductor nanowires 506 and overlies the insulator layer 505 (and in one embodiment is along a top and sides of the insulator layer 505, although only the former depicted in the view of Figure 5 where side coverage by the gate stack 508A/508B along sides of the insulator layer 505 is at locations into and out of the page of the perspective of Figure 5). A pair of non-discrete epitaxial source or drain structures 510 is at first and second ends of the vertical arrangement of horizontal semiconductor nanowires 506 and on the insulator layer 505. In accordance with an embodiment of the present disclosure, the gate dielectric 508B includes a high-k dielectric layer continuous with and having a same composition as the insulator layer 505, such as described in association with Figure 3.

A pair of dielectric spacers 512 is between the pair of non-discrete epitaxial source or drain structures 510 and the gate stack 508A/508B. In one embodiment, the pair of dielectric spacers 512 and the gate stack 508A/508B have co-planar top surfaces, e.g., at surface 520, as is depicted. In one such embodiment, an etch stop layer or dielectric layer 516 is formed on the surface 520.

In an embodiment, one or both of the pair of non-discrete epitaxial source or drain structures has a dielectric material thereon (represented by 514 in one embodiment). In one such embodiment, wherein the dielectric material 514, the pair of dielectric spacers 512 and the gate stack 508A/508B have co-planar top surfaces, as is depicted at surface 520. In an embodiment, one or both of the pair of non-discrete epitaxial source or drain structures has a top conductive contact thereon (represented by 514 in another embodiment). In one such embodiment, wherein the top conductive contact 514, the pair of dielectric spacers 512 and the gate stack 508A/508B have co-planar top surfaces, as is depicted at surface 520. In an embodiment, insulator layer 505 blocks or eliminates a parasitic conduction path (e.g., path 560 from Source 510 to Drain 510) for improved device performance.

It is to be appreciated that, in a particular embodiment, channel layers of nanowires (or nanoribbons or nanosheets), or source or drain structures (or release layers between channel layers of nanowires), may be composed of silicon. As used throughout, a silicon layer may be used to describe a silicon material composed of a very substantial amount of, if not all, silicon. However, it is to be appreciated that, practically, 100% pure Si may be difficult to form and, hence, could include a tiny percentage of carbon, germanium or tin. Such impurities may be included as an unavoidable impurity or component during deposition of Si or may "contaminate" the Si upon diffusion during post deposition processing. As such, embodiments described herein directed to a silicon layer may include a silicon layer that contains a relatively small amount, e.g., "impurity" level, non-Si atoms or species, such as Ge, C or Sn. It is to be appreciated that a silicon layer as described herein may be undoped or may be doped with dopant atoms such as boron, phosphorous or arsenic.

It is to be appreciated that, in a particular embodiment, release layers between channel layers of nanowires (or nanoribbons or nanosheets), or source or drain structures, or channel layers, may be composed of silicon germanium. As used throughout, a silicon germanium layer may be used to describe a silicon germanium material composed of substantial portions of both silicon and germanium, such as at least 5% of both. In some embodiments, the amount of germanium is greater than the amount of silicon. In particular embodiments, a silicon germanium layer includes approximately 60% germanium and approximately 40% silicon (Si₄₀Ge₆₀). In other embodiments, the amount of silicon is greater than the amount of germanium. In particular embodiments, a silicon germanium layer includes approximately 30% germanium and approximately 70% silicon (Si₇₀Ge₃₀). It is to be appreciated that, practically, 100% pure silicon germanium (referred to generally as SiGe) may be difficult to form and, hence, could include a tiny percentage of carbon or tin. Such impurities may be included as an unavoidable impurity or component during deposition of SiGe or may "contaminate" the SiGe upon diffusion during post deposition processing. As such, embodiments described herein directed to a silicon germanium layer may include a silicon germanium layer that contains a relatively small amount, e.g., "impurity" level, non-Ge and non-Si atoms or species, such as carbon or tin. It is to be appreciated that a silicon germanium layer as described herein may be undoped or may be doped with dopant atoms such as boron, phosphorous or arsenic.

It is to be appreciated that, in a particular embodiment, channel layers of nanowires (or nanoribbons or nanosheets), or source or drain structures, may be composed of germanium. As used throughout, a germanium layer may be used to describe a germanium material composed of a very substantial amount of, if not all, germanium. However, it is to be appreciated that, practically, 100% pure Ge may be difficult to form and, hence, could include a tiny percentage of carbon, silicon or tin. Such impurities may be included as an unavoidable impurity or component during deposition of Ge or may "contaminate" the Ge upon diffusion during post deposition processing. As such, embodiments described herein directed to a germanium layer may include a germanium layer that contains a relatively small amount, e.g., "impurity" level, non-Ge atoms or species, such as Si, C or Sn. It is to be appreciated that a germanium layer as described herein may be undoped or may be doped with dopant atoms such as boron, phosphorous or arsenic.

It is to be appreciated that the embodiments described herein can also include other implementations such as nanowires and/or nanoribbons and/or nanosheets with various widths, thicknesses and/or materials including but not limited to Si, Ge, SiGe and/or Group III-V materials. Described below are various devices and processing schemes that may be used to fabricate a device with strained source or drain structures on a gate dielectric layer. It is to be appreciated that the exemplary embodiments need not necessarily require all features described, or may include more features than are described.

In another aspect, integrated circuit structures described herein may be fabricated using a back-side reveal of front-side structures fabrication approach. In some exemplary embodiments, reveal of the back-side of a transistor or other device structure entails wafer-level back-side processing. A reveal of the back-side of a transistor approach may be employed for example to remove at least a portion of a carrier layer and intervening layer of a donor-host substrate assembly. The process flow begins with an input of a donor-host substrate assembly. A thickness of a carrier layer in the donor-host substrate is polished (e.g., CMP) and/or etched with a wet or dry (e.g., plasma) etch process. Any grind, polish, and/or wet/dry etch process known to be suitable for the composition of the carrier layer may be employed. For example, where the carrier layer is a group IV semiconductor (e.g., silicon) a CMP slurry known to be suitable for thinning the semiconductor may be employed. Likewise, any wet etchant or plasma etch process known to be suitable for thinning the group IV semiconductor may also be employed.

In some embodiments, the above is preceded by cleaving the carrier layer along a fracture plane substantially parallel to the intervening layer. The cleaving or fracture process may be utilized to remove a substantial portion of the carrier layer as a bulk mass, reducing the polish or etch time needed to remove the carrier layer. For example, where a carrier layer is 400-900 µm in thickness, 100-700 µm may be cleaved off by practicing any blanket implant known to promote a wafer-level fracture. In some exemplary embodiments, a light element (e.g., H, He, or Li) is implanted to a uniform target depth within the carrier layer where the fracture plane is desired. Following such a cleaving process, the thickness of the carrier layer remaining in the donor-host substrate assembly may then be polished or etched to complete removal. Alternatively, where the carrier layer is not fractured, the grind, polish and/or etch operation may be employed to remove a greater thickness of the carrier layer.

Next, exposure of an intervening layer is detected. Detection is used to identify a point when the back-side surface of the donor substrate has advanced to nearly the device layer. Any endpoint detection technique known to be suitable for detecting a transition between the materials employed for the carrier layer and the intervening layer may be practiced. In some embodiments, one or more endpoint criteria are based on detecting a change in optical absorbance or emission of the back-side surface of the donor substrate during the polishing or etching performed. In some other embodiments, the endpoint criteria are associated with a change in optical absorbance or emission of byproducts during the polishing or etching of the donor substrate back-side surface. For example, absorbance or emission wavelengths associated with the carrier layer etch byproducts may change as a function of the different compositions of the carrier layer and intervening layer. In other embodiments, the endpoint criteria are associated with a change in mass of species in byproducts of polishing or etching the back-side surface of the donor substrate. For example, the byproducts of processing may be sampled through a quadrupole mass analyzer and a change in the species mass may be correlated to the different compositions of the carrier layer and intervening layer. In another exemplary embodiment, the endpoint criteria is associated with a change in friction between a back-side surface of the donor substrate and a polishing surface in contact with the back-side surface of the donor substrate.

Detection of the intervening layer may be enhanced where the removal process is selective to the carrier layer relative to the intervening layer as non-uniformity in the carrier removal process may be mitigated by an etch rate delta between the carrier layer and intervening layer. Detection may even be skipped if the grind, polish and/or etch operation removes the intervening layer at a rate sufficiently below the rate at which the carrier layer is removed. If an endpoint criteria is not employed, a grind, polish and/or etch operation of a predetermined fixed duration may stop on the intervening layer material if the thickness of the intervening layer is sufficient for the selectivity of the etch. In some examples, the carrier etch rate: intervening layer etch rate is 3:1-10:1, or more.

Upon exposing the intervening layer, at least a portion of the intervening layer may be removed. For example, one or more component layers of the intervening layer may be removed. A thickness of the intervening layer may be removed uniformly by a polish, for example. Alternatively, a thickness of the intervening layer may be removed with a masked or blanket etch process. The process may employ the same polish or etch process as that employed to thin the carrier, or may be a distinct process with distinct process parameters. For example, where the intervening layer provides an etch stop for the carrier removal process, the latter operation may employ a different polish or etch process that favors removal of the intervening layer over removal of the device layer. Where less than a few hundred nanometers of intervening layer thickness is to be removed, the removal process may be relatively slow, optimized for across-wafer uniformity, and more precisely controlled than that employed for removal of the carrier layer. A CMP process employed may, for example employ a slurry that offers very high selectively (e.g., 100:1-300:1, or more) between semiconductor (e.g., silicon) and dielectric material (e.g., SiO) surrounding the device layer and embedded within the intervening layer, for example, as electrical isolation between adjacent device regions.

For embodiments where the device layer is revealed through complete removal of the intervening layer, back-side processing may commence on an exposed back-side of the device layer or specific device regions there in. In some embodiments, the back-side device layer processing includes a further polish or wet/dry etch through a thickness of the device layer disposed between the intervening layer and a device region previously fabricated in the device layer, such as a source or drain region.

The above described processing scheme may result in a donor-host substrate assembly that includes IC devices that have a back-side of an intervening layer, a back-side of the device layer, and/or back-side of one or more semiconductor regions within the device layer, and/or front-side metallization revealed. Additional back-side processing of any of these revealed regions may then be performed during downstream processing. In accordance with one or more embodiments of the present disclosure, following a backside reveal process an insulator substrate, such as a substrate having an insulator layer (such as silicon oxide) on a bulk semiconductor material (such as crystalline silicon) is bonded to exposed bottom surfaces of the bottommost wires (fins) and to exposed bottom surfaces of epitaxial source or drain structures.

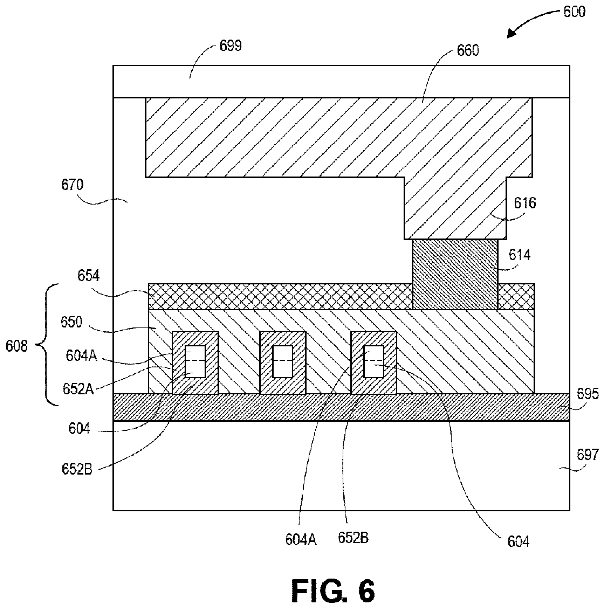

It is to be appreciated that the structures resulting from the above exemplary processing schemes may be used in a same or similar form for subsequent processing operations to complete device fabrication, such as PMOS and/or NMOS device fabrication. As an example of a possible completed device, and as another exemplary device having strained source or drain structures on a gate dielectric layer on a substrate, Figure 6 illustrates a cross-sectional views of a non-planar integrated circuit structure as taken along a gate line, in accordance with an embodiment of the present disclosure.

Referring to Figure 6, a semiconductor structure or device 600 includes a non-planar active region (e.g., a fin structure including protruding fin portion 604) on an optional buffer layer 695 of a substrate 697/695. In an embodiment, instead of a solid fin, the non-planar active region only includes region 604A to provide a semiconductor nanowire 604A and an insulator layer 652B with the gate structure 608 beneath the region 604A. In either case, for ease of description for non-planar integrated circuit structure 600, a non-planar active region 604 is referenced below as a protruding fin portion.

A gate line 608 is disposed over the protruding portions 604 of the non-planar active region (including, if applicable, surrounding nanowire 604A and insulator layer 652B), as well as over a portion of the optional buffer layer 695. As shown, gate line 608 includes a gate electrode 650 and a gate dielectric layer 652A. In one embodiment, gate line 608 may also include a dielectric cap layer 654. In accordance with an embodiment of the present disclosure, the gate dielectric layer 652A includes a high-k dielectric layer continuous with and having a same composition as the insulator layer 652B, such as described in association with Figure 3.

A gate contact 614, and overlying gate contact via 616 are also seen from this perspective, along with an overlying metal interconnect 660, all of which are disposed in inter-layer dielectric stacks or layers 670. An etch stop layer 699 may be formed on the interconnect 660 and inter-layer dielectric stacks or layers 670, as is depicted. Also seen from the perspective of Figure 6, the gate contact 614 is, in one embodiment, disposed over optional buffer layer 695, but not over the non-planar active regions. In another embodiment, however, the gate contact 614 is over the non-planar active regions.

In an embodiment, the semiconductor structure or device 600 is a non-planar device such as, but not limited to, a fin-FET device, a tri-gate device, a nanoribbon device, or a nanowire device. In such an embodiment, a corresponding semiconducting channel region is composed of or is formed in a three-dimensional body. In one such embodiment, the gate stacks of gate lines 608 surround at least a top surface and a pair of sidewalls of the three-dimensional body.

Although not depicted in Figure 6, it is to be appreciated that strained source or drain regions of or adjacent to the protruding fin portions 604 are on either side of the gate line 608, i.e., into and out of the page. In one embodiment, the material of the protruding fin portions 604 in the source or drain locations is removed and replaced with another semiconductor material, e.g., by epitaxial deposition to form epitaxial source or drain structures. The source or drain regions may extend to the top surface of the optional buffer layer 695. In accordance with an embodiment of the present disclosure, the insulator layer 652B inhibits source to drain leakage. With reference again to Figure 6, in an embodiment, nanowires 604A are composed of crystalline silicon layer which may be doped with a charge carrier, such as but not limited to phosphorus, arsenic, boron, gallium or a combination thereof.

Gate line 608 may be composed of a gate stack which includes a gate dielectric layer 652A and a gate electrode layer 650. In an embodiment, the gate electrode layer 650 of the gate stack is composed of a metal gate and the gate dielectric layer is composed of a high-k material. For example, in one embodiment, the gate dielectric layer 652A is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of gate dielectric layer 652A may include a layer of native oxide formed from the top few layers of the nanowires 604A. In an embodiment, the gate dielectric layer 652A is composed of a top high-k portion and a lower portion composed of an oxide of a semiconductor material. In one embodiment, the gate dielectric layer 652A is composed of a top portion of hafnium oxide and a bottom portion of silicon dioxide or silicon oxy-nitride. In some implementations, a portion of the gate dielectric is a "U"-shaped structure that includes a bottom portion substantially parallel to the surface of the substrate and two sidewall portions that are substantially perpendicular to the top surface of the substrate.

In one embodiment, the gate electrode layer 650 is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode layer 650 is composed of a non-workfunction-setting fill material formed above a metal workfunction-setting layer. The gate electrode layer 650 may consist of a P-type workfunction metal or an N-type workfunction metal, depending on whether the transistor is to be a PMOS or an NMOS transistor. In some implementations, the gate electrode layer 650 may consist of a stack of two or more metal layers, where one or more metal layers are workfunction metal layers and at least one metal layer is a conductive fill layer. For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV. In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode layer 650 may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode may consist of one or more U-shaped metal layers formed atop one or more planar, non-U-shaped layers.

Spacers associated with the gate stacks may be composed of a material suitable to ultimately electrically isolate, or contribute to the isolation of, a permanent gate structure from adjacent conductive contacts, such as self-aligned contacts. For example, in one embodiment, the spacers are composed of a dielectric material such as, but not limited to, silicon dioxide, silicon oxy-nitride, silicon nitride, or carbon-doped silicon nitride.

Gate contact 614 and overlying gate contact via 616 may be composed of a conductive material. In an embodiment, one or more of the contacts or vias are composed of a metal species. The metal species may be a pure metal, such as tungsten, nickel, or cobalt, or may be an alloy such as a metal-metal alloy or a metal-semiconductor alloy (e.g., such as a silicide material).

In an embodiment (although not shown), a contact pattern which is essentially perfectly aligned to an existing gate pattern 608 is formed while eliminating the use of a lithographic operation with exceedingly tight registration budget. In an embodiment, the contact pattern is a vertically symmetric contact pattern, or an asymmetric contact pattern. In other embodiments, all contacts are front-side connected and are not asymmetric. In one such embodiment, the self-aligned approach enables the use of intrinsically highly selective wet etching (e.g., versus conventionally implemented dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in conventional approaches. In an embodiment, a trench contact grid is not separately patterned, but is rather formed between poly (gate) lines. For example, in one such embodiment, a trench contact grid is formed subsequent to gate grating patterning but prior to gate grating cuts.

In an embodiment, providing structure 600 involves fabrication of the gate stack structure 608 by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of polycrystalline silicon or amorphous silicon and are removed with a dry etch process including use of SF₆. In another embodiment, dummy gates are composed of polycrystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

Referring again to Figure 6, the arrangement of semiconductor structure or device 600 places the gate contact over isolation regions. Such an arrangement may be viewed as inefficient use of layout space. In another embodiment, however, a semiconductor device has contact structures that contact portions of a gate electrode formed over an active region, e.g., over a nanowire 604A, and in a same layer as a trench contact via.

It is to be appreciated that not all aspects of the processes described above need be practiced to fall within the spirit and scope of embodiments of the present disclosure. Also, the processes described herein may be used to fabricate one or a plurality of semiconductor devices. The semiconductor devices may be transistors or like devices. For example, in an embodiment, the semiconductor devices are a metal-oxide semiconductor (MOS) transistors for logic or memory, or are bipolar transistors. Also, in an embodiment, the semiconductor devices have a three-dimensional architecture, such as a nanowire device, a nanoribbon device, a tri-gate device, an independently accessed double gate device, or a FIN-FET. One or more embodiments may be particularly useful for fabricating semiconductor devices at a sub-10 nanometer (10 nm) technology node.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by conventional techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials, capping layers, or plugs are composed of dielectric materials different from the interlayer dielectric material. In one embodiment, different hardmask, capping or plug materials may be used in different regions so as to provide different growth or etch selectivity to each other and to the underlying dielectric and metal layers. In some embodiments, a hardmask layer, capping or plug layer includes a layer of a nitride of silicon (e.g., silicon nitride) or a layer of an oxide of silicon, or both, or a combination thereof. Other suitable materials may include carbon-based materials. Other hardmask, capping or plug layers known in the arts may be used depending upon the particular implementation. The hardmask, capping or plug layers maybe formed by CVD, PVD, or by other deposition methods.

In an embodiment, as is also used throughout the present description, lithographic operations are performed using 193nm immersion lithography (i193), EUV and/or EBDW lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

In another aspect, one or more embodiments are directed to neighboring semiconductor structures or devices separated by self-aligned gate endcap (SAGE) structures. Particular embodiments may be directed to integration of multiple width (multi-Wsi) nanowires and nanoribbons in a SAGE architecture and separated by a SAGE wall. In an embodiment, nanowires/nanoribbons are integrated with multiple Wsi in a SAGE architecture portion of a front-end process flow. Such a process flow may involve integration of nanowires and nanoribbons of different Wsi to provide robust functionality of next generation transistors with low power and high performance. Associated epitaxial source or drain regions may be embedded (e.g., portions of nanowires removed and then source or drain (S/D) growth is performed).

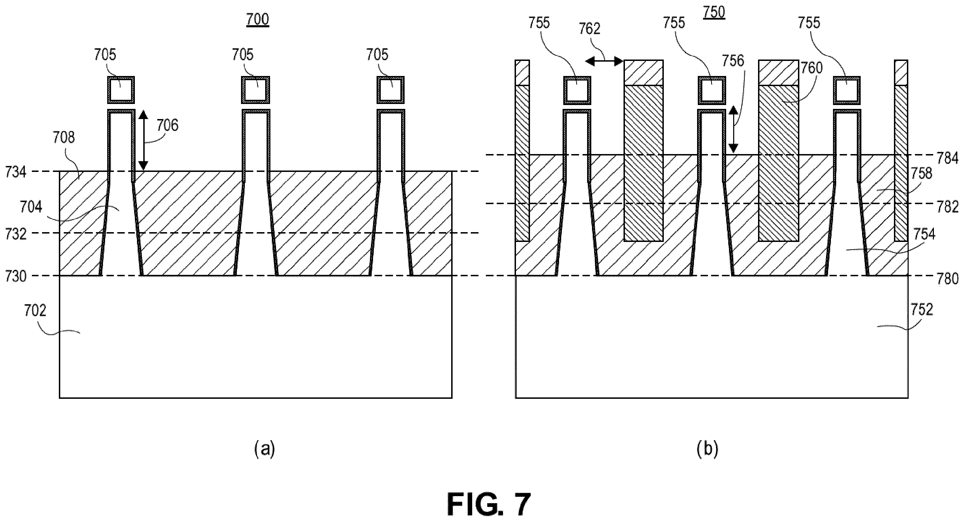

To provide further context, advantages of a self-aligned gate endcap (SAGE) architecture may include the enabling of higher layout density and, in particular, scaling of diffusion to diffusion spacing. To provide illustrative comparison, Figure 7 illustrates cross-sectional views taken through nanowires and fins for a non-endcap architecture (left-hand side (a)) versus a self-aligned gate endcap (SAGE) architecture (right-hand side (b)), in accordance with an embodiment of the present disclosure.

Referring to the left-hand side (a) of Figure 7, an integrated circuit structure 700 includes a substrate 702 having fins 704 protruding there from by an amount 706 above an isolation structure 708 laterally surrounding lower portions of the fins 704. Corresponding nanowires 705 are over the fins 704. A gate structure may be formed over the integrated circuit structure 700 to fabricate a device. However, breaks in such a gate structure may be accommodated for by increasing the spacing between fin 704/nanowire 705 pairs.

Referring again to part (a) of Figure 7, in an embodiment, during a replacement gate process, an etch stop layer may be replaced with a gate dielectric layer to form an insulator layer beneath the nanowires 705 and beneath associated source or drain structures (located into and out of the page). Deposition may be only on the exposed portion (i.e., to level 734) but could also extend into the fin (i.e., to level 732) or all the way through the fin (i.e., to level 730), effectively providing an insulator layer on a bulk substrate (as opposed to on an insulator substrate as described above).

By contrast, referring to the right-hand side (b) of Figure 7, an integrated circuit structure 750 includes a substrate 752 having fins 754 protruding therefrom by an amount 756 above an isolation structure 758 laterally surrounding lower portions of the fins 754. Corresponding nanowires 755 are over the fins 754. Isolating SAGE walls 760 (which may include a hardmask thereon, as depicted) are included within the isolation structure 758 and between adjacent fin 754/nanowire 755 pairs. The distance between an isolating SAGE wall 760 and a nearest fin 754/nanowire 755 pair defines the gate endcap spacing 762. A gate structure may be formed over the integrated circuit structure 750, between insolating SAGE walls to fabricate a device. Breaks in such a gate structure are imposed by the isolating SAGE walls. Since the isolating SAGE walls 760 are self-aligned, restrictions from conventional approaches can be minimized to enable more aggressive diffusion to diffusion spacing. Furthermore, since gate structures include breaks at all locations, individual gate structure portions may be layer connected by local interconnects formed over the isolating SAGE walls 760. In an embodiment, as depicted, the SAGE walls 760 each include a lower dielectric portion and a dielectric cap on the lower dielectric portion.

Referring again to part (b) of Figure 7, in an embodiment, during a replacement gate process, an etch stop layer may be replaced with a gate dielectric layer to form an insulator layer beneath the nanowires 755 and beneath associated source or drain structures (located into and out of the page). Deposition may be only for the exposed portion (i.e., to level 784) but could also extend into the fin (i.e., to level 782) or all the way through the fin (i.e., to level 780), effectively providing an insulator layer on a bulk substrate (as opposed to on an insulator substrate as described above).

A self-aligned gate endcap (SAGE) processing scheme involves the formation of gate/trench contact endcaps self-aligned to fins without requiring an extra length to account for mask mis-registration. Thus, embodiments may be implemented to enable shrinking of transistor layout area. Embodiments described herein may involve the fabrication of gate endcap isolation structures, which may also be referred to as gate walls, isolation gate walls or self-aligned gate endcap (SAGE) walls.

In an embodiment, as described throughout, self-aligned gate endcap (SAGE) isolation structures may be composed of a material or materials suitable to ultimately electrically isolate, or contribute to the isolation of, portions of permanent gate structures from one another. Exemplary materials or material combinations include a single material structure such as silicon dioxide, silicon oxy-nitride, silicon nitride, or carbon-doped silicon nitride. Other exemplary materials or material combinations include a multi-layer stack having lower portion silicon dioxide, silicon oxy-nitride, silicon nitride, or carbon-doped silicon nitride and an upper portion higher dielectric constant material such as hafnium oxide.

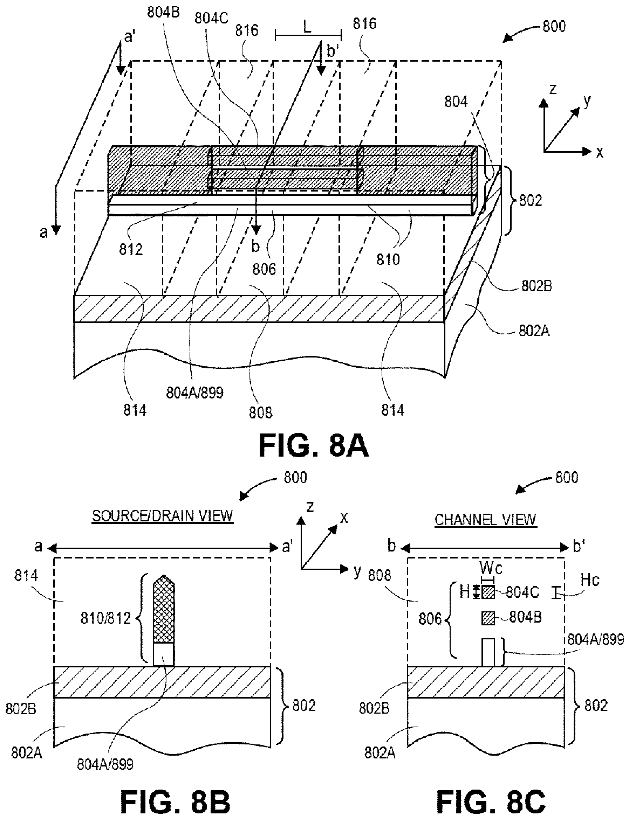

To highlight an exemplary integrated circuit structure having two vertically arranged nanowires over an insulator layer (which may be continuous with a gate dielectric layer, Figure 8A illustrates a three-dimensional cross-sectional view of a nanowire-based integrated circuit structure, in accordance with an embodiment of the present disclosure. Figure 8B illustrates a cross-sectional source or drain view of the nanowire-based integrated circuit structure of Figure 8A, as taken along the a-a' axis. Figure 8C illustrates a cross-sectional channel view of the nanowire-based integrated circuit structure of Figure 8A, as taken along the b-b' axis.

Referring to Figure 8A, an integrated circuit structure 800 includes one or more vertically stacked nanowires (804 set) above a substrate 802. In an embodiment, as depicted, a semiconductor buffer layer 802B and a bulk semiconductor layer 802A are included in substrate 802, as is depicted. Embodiments herein are targeted at both single wire devices and multiple wire devices. As an example, a two nanowire-based devices having nanowires 804B and 804C is shown for illustrative purposes. For convenience of description, nanowire 804B is used as an example where description is focused on one of the nanowires. It is to be appreciated that where attributes of one nanowire are described, embodiments based on a plurality of nanowires may have the same or essentially the same attributes for each of the nanowires. In either case, the one nanowire or the plurality of nanowires is over an insulator layer 899.

Each of the nanowires 804B and 804C includes a channel region 806 in the nanowire. The channel region 806 has a length (L). The channel region also has a perimeter orthogonal to the length (L). Referring to both Figures 8A and 8C, a gate stack 808 surrounds the entire perimeter of each of the channel regions 806. The gate stack 808 includes a gate electrode along with a gate dielectric layer between the channel region 806 and the gate electrode (not shown). In accordance with an embodiment of the present disclosure, the gate dielectric layer of the gate stack 808 includes a high-k dielectric layer continuous with and having a same composition as the insulator layer 899, such as described in association with Figure 3. In an embodiment, the channel region is discrete in that it is completely surrounded by the gate stack 808 without any intervening material such as underlying substrate material or overlying channel fabrication materials. Accordingly, in embodiments having a plurality of nanowires 804, the channel regions 806 of the nanowires are also discrete relative to one another.

Referring to both Figures 8A and 8B, integrated circuit structure 800 includes a pair of non-discrete source or drain regions 810/812. The pair of non-discrete source or drain regions 810/812 is on either side of the channel regions 806 of the plurality of vertically stacked nanowires 804, and on the insulator layer 899/804A. Furthermore, the pair of non-discrete source or drain regions 810/812 is adjoining for the channel regions 806 of the plurality of vertically stacked nanowires 804. In one such embodiment, not depicted, the pair of non-discrete source or drain regions 810/812 is directly vertically adjoining for the channel regions 806 in that epitaxial growth is on and between nanowire portions extending beyond the channel regions 806, where nanowire ends are shown within the source or drain structures. In another embodiment, as depicted in Figure 8A, the pair of non-discrete source or drain regions 810/812 is indirectly vertically adjoining for the channel regions 806 in that they are formed at the ends of the nanowires and not between the nanowires.

In an embodiment, as depicted, the source or drain regions 810/812 are non-discrete in that there are not individual and discrete source or drain regions for each channel region 806 of a nanowire 804. Accordingly, in embodiments having a plurality of nanowires 804, the source or drain regions 810/812 of the nanowires are global or unified source or drain regions as opposed to discrete for each nanowire. That is, the non-discrete source or drain regions 810/812 are global in the sense that a single unified feature is used as a source or drain region for a plurality (in this case, 3) of nanowires 804 and, more particularly, for more than one discrete channel region 806. In one embodiment, from a cross-sectional perspective orthogonal to the length of the discrete channel regions 806, each of the pair of non-discrete source or drain regions 810/812 is approximately rectangular in shape with top vertex portion, as depicted in Figure 8B. In other embodiments, however, the source or drain regions 810/812 of the nanowires are relatively larger yet discrete non-vertically merged epitaxial structures such as nubs.

In accordance with an embodiment of the present disclosure, and as depicted in Figures 8A and 8B, integrated circuit structure 800 further includes a pair of contacts 814, each contact 814 on one of the pair of non-discrete source or drain regions 810/812. In one such embodiment, in a vertical sense, each contact 814 completely surrounds the respective non-discrete source or drain region 810/812. In another aspect, the entire perimeter of the non-discrete source or drain regions 810/812 may not be accessible for contact with contacts 814, and the contact 814 thus only partially surrounds the non-discrete source or drain regions 810/812, as depicted in Figure 8B. In a contrasting embodiment, not depicted, the entire perimeter of the non-discrete source or drain regions 810/812, as taken along the a-a' axis, is surrounded by the contacts 814.

Referring again to Figure 8A, in an embodiment, integrated circuit structure 800 further includes a pair of spacers 816. As is depicted, outer portions of the pair of spacers 816 may overlap portions of the non-discrete source or drain regions 810/812, providing for "embedded" portions of the non-discrete source or drain regions 810/812 beneath the pair of spacers 816. As is also depicted, the embedded portions of the non-discrete source or drain regions 810/812 may not extend beneath the entirety of the pair of spacers 816.

In an embodiment, the nanowires 804B and 804C may be sized as wires or ribbons, as described below, and may have squared-off or rounder corners. In an embodiment, the nanowires 804B and 804C are composed of a material such as, but not limited to, silicon, germanium, or a combination thereof. In one such embodiment, the nanowires are single-crystalline. For example, for a silicon nanowire, a single-crystalline nanowire may be based from a (100) global orientation, e.g., with a <100> plane in the z-direction. As described below, other orientations may also be considered. In an embodiment, the dimensions of the nanowires, from a cross-sectional perspective, are on the nano-scale. For example, in a specific embodiment, the smallest dimension of the nanowire is less than approximately 20 nanometers. In an embodiment, the nanowires are composed of a strained material, particularly in the channel regions 806.

Referring to Figures 8C, in an embodiment, each of the channel regions 806 has a width (Wc) and a height (Hc), the width (Wc) approximately the same as the height (Hc). That is, in both cases, the channel regions 806 are square-like or, if corner-rounded, circle-like in cross-section profile. In another aspect, the width and height of the channel region need not be the same, such as the case for nanoribbons as described throughout.

In an embodiment, as described throughout, an integrated circuit structure effectively includes a non-planar device such as, but not limited to, a finFET or a tri-gate device, with corresponding one or more overlying nanowire structures. In one embodiment, a gate structure surrounds each of the one or more discrete nanowire channel portions.

In an embodiment, as described throughout, an underlying semiconductor substrate may be composed of a semiconductor material that can withstand a manufacturing process and in which charge can migrate. In an embodiment, the substrate is a bulk substrate composed of a crystalline silicon, silicon/germanium or germanium layer doped with a charge carrier, such as but not limited to phosphorus, arsenic, boron, gallium or a combination thereof, to form an active region. In one embodiment, the concentration of silicon atoms in a bulk substrate is greater than 97%. In another embodiment, a bulk substrate is composed of an epitaxial layer grown atop a distinct crystalline substrate, e.g. a silicon epitaxial layer grown atop a boron-doped bulk silicon mono-crystalline substrate. A bulk substrate may alternatively be composed of a group III-V material. In an embodiment, a bulk substrate is composed of a group III-V material such as, but not limited to, gallium nitride, gallium phosphide, gallium arsenide, indium phosphide, indium antimonide, indium gallium arsenide, aluminum gallium arsenide, indium gallium phosphide, or a combination thereof. In one embodiment, a bulk substrate is composed of a group III-V material and the charge-carrier dopant impurity atoms are ones such as, but not limited to, carbon, silicon, germanium, oxygen, sulfur, selenium or tellurium.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

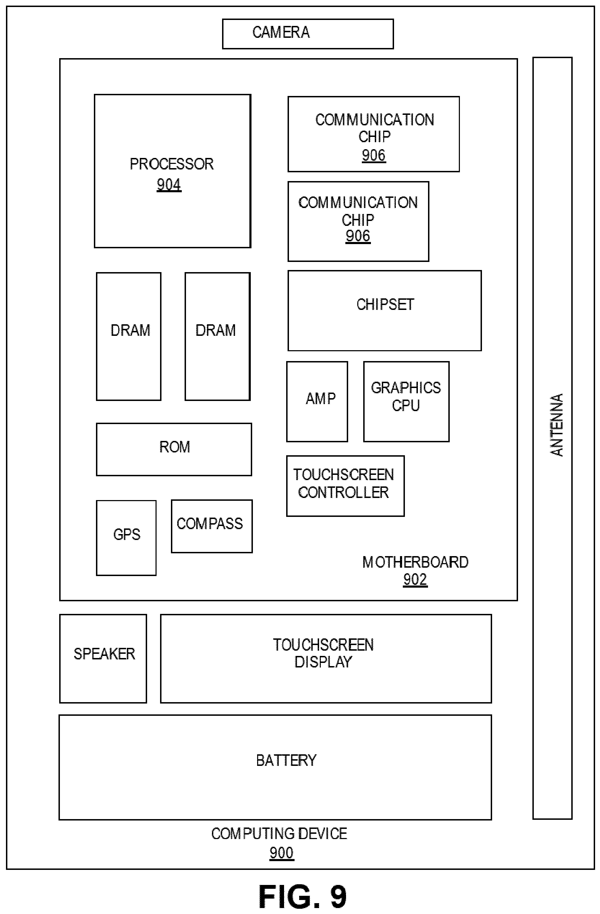

Figure 9 illustrates a computing device 900 in accordance with one implementation of an embodiment of the present disclosure. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. The integrated circuit die of the processor 904 may include one or more structures, such as gate-all-around integrated circuit structures having strained source or drain structures on a gate dielectric layer, built in accordance with implementations of embodiments of the present disclosure. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. The integrated circuit die of the communication chip 906 may include one or more structures, such as gate-all-around integrated circuit structures having strained source or drain structures on a gate dielectric layer, built in accordance with implementations of embodiments of the present disclosure.

In further implementations, another component housed within the computing device 900 may contain an integrated circuit die that includes one or structures, such as gate-all-around integrated circuit structures having strained source or drain structures on a gate dielectric layer, built in accordance with implementations of embodiments of the present disclosure.

In various implementations, the computing device 900 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

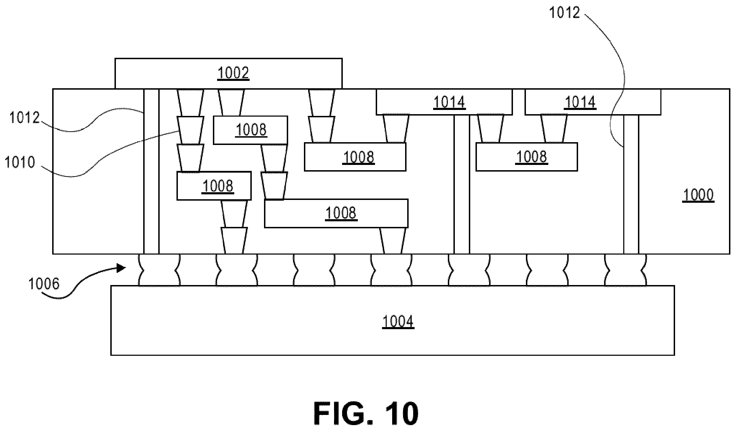

Figure 10 illustrates an interposer 1000 that includes one or more embodiments of the present disclosure. The interposer 1000 is an intervening substrate used to bridge a first substrate 1002 to a second substrate 1004. The first substrate 1002 may be, for instance, an integrated circuit die. The second substrate 1004 may be, for instance, a memory module, a computer motherboard, or another integrated circuit die. Generally, the purpose of an interposer 1000 is to spread a connection to a wider pitch or to reroute a connection to a different connection. For example, an interposer 1000 may couple an integrated circuit die to a ball grid array (BGA) 1006 that can subsequently be coupled to the second substrate 1004. In some embodiments, the first and second substrates 1002/1004 are attached to opposing sides of the interposer 1000. In other embodiments, the first and second substrates 1002/1004 are attached to the same side of the interposer 1000. And in further embodiments, three or more substrates are interconnected by way of the interposer 1000.

The interposer 1000 may be formed of an epoxy resin, a fiberglass-reinforced epoxy resin, a ceramic material, or a polymer material such as polyimide. In further implementations, the interposer 1000 may be formed of alternate rigid or flexible materials that may include the same materials described above for use in a semiconductor substrate, such as silicon, germanium, and other group III-V and group IV materials.

The interposer 1000 may include metal interconnects 1008 and vias 1010, including but not limited to through-silicon vias (TSVs) 1012. The interposer 1000 may further include embedded devices 1014, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1000. In accordance with embodiments of the disclosure, apparatuses or processes disclosed herein may be used in the fabrication of interposer 1000 or in the fabrication of components included in the interposer 1000.

Thus, embodiments of the present disclosure include gate-all-around integrated circuit structures having strained source or drain structures on a gate dielectric layer, and methods of fabricating gate-all-around integrated circuit structures having strained source or drain structures on a gate dielectric layer.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.
Example embodiment 1: An integrated circuit structure includes an insulator layer above a substrate. A vertical arrangement of horizontal semiconductor nanowires is over the insulator layer. A pair of epitaxial source or drain structures is at first and second ends of the vertical arrangement of horizontal semiconductor nanowires and on the insulator layer. A gate stack is surrounding a channel region of the vertical arrangement of horizontal semiconductor nanowires. The gate stack includes a high-k dielectric layer continuous with and having a same composition as the insulator layer.
Example embodiment 2: The integrated circuit structure of example embodiment 1, wherein each of the pair of epitaxial source or drain structures has a compressed lattice.
Example embodiment 3: The integrated circuit structure of example embodiment 1, wherein each of the pair of epitaxial source or drain structures has an expanded lattice.
Example embodiment 4: The integrated circuit structure of example embodiment 1, 2 or 3, wherein the insulator layer is on a sub-fin, the sub-fin above or on the substrate.
Example embodiment 5: The integrated circuit structure of example embodiment 1, 2, 3 or 4, wherein the vertical arrangement of horizontal semiconductor nanowires includes silicon.
Example embodiment 6: The integrated circuit structure of example embodiment 1, 2, 3, 4 or 5, wherein the pair of epitaxial source or drain structures is a pair of non-discrete epitaxial source or drain structures.
Example embodiment 7: The integrated circuit structure of example embodiment 1, 2, 3, 4, 5 or 6, wherein the gate stack includes a metal gate electrode.
Example embodiment 8: The integrated circuit structure of example embodiment 1, 2, 3, 4, 5, 6 or 7, wherein the semiconductor material of the pair of epitaxial source or drain structures is silicon.
Example embodiment 9: The integrated circuit structure of example embodiment 1, 2, 3, 4, 5, 6 or 7, wherein the semiconductor material of the pair of epitaxial source or drain structures is silicon germanium.
Example embodiment 10: An integrated circuit structure includes a vertical arrangement of horizontal semiconductor nanowires above a substrate. A gate stack is surrounding a channel region of the vertical arrangement of horizontal semiconductor nanowires. The gate stack includes a high-k dielectric layer having a lowermost portion extending laterally beyond first and second ends of the vertical arrangement of horizontal semiconductor nanowires. A pair of epitaxial source or drain structures is at the first and second ends of the vertical arrangement of horizontal semiconductor nanowires and on the lowermost portion of the high-k dielectric layer of the gate stack.
Example embodiment 11: The integrated circuit structure of example embodiment 10, wherein each of the pair of epitaxial source or drain structures has a compressed lattice.
Example embodiment 12: The integrated circuit structure of example embodiment 10, wherein each of the pair of epitaxial source or drain structures has an expanded lattice.
Example embodiment 13: The integrated circuit structure of example embodiment 10, 11 or 12, wherein the insulator layer is on a sub-fin, the sub-fin above or on the substrate.
Example embodiment 14: The integrated circuit structure of example embodiment 10, 11, 12 or 13, wherein the vertical arrangement of horizontal semiconductor nanowires includes silicon.
Example embodiment 15: The integrated circuit structure of example embodiment 10, 11, 12, 13 or 14, wherein the pair of epitaxial source or drain structures is a pair of non-discrete epitaxial source or drain structures.
Example embodiment 16: A computing device includes a board, and a component coupled to the board. The component includes an integrated circuit structure including an insulator layer above a substrate. A vertical arrangement of horizontal semiconductor nanowires is over the insulator layer. A pair of epitaxial source or drain structures is at first and second ends of the vertical arrangement of horizontal semiconductor nanowires and on the insulator layer. A gate stack is surrounding a channel region of the vertical arrangement of horizontal semiconductor nanowires. The gate stack includes a high-k dielectric layer continuous with and having a same composition as the insulator layer.
Example embodiment 17: The computing device of example embodiment 16, further including a memory coupled to the board.
Example embodiment 18: The computing device of example embodiment 16 or 17, further including a communication chip coupled to the board.
Example embodiment 19: The computing device of example embodiment 16, 17 or 18, wherein the component is a packaged integrated circuit die.
Example embodiment 20: The computing device of example embodiment 16, 17, 18 or 19, wherein the component is selected from the group consisting of a processor,
   a communications chip, and a digital signal processor.

## Claims

1. An integrated circuit structure, comprising:
an insulator layer above a substrate;
a vertical arrangement of horizontal semiconductor nanowires over the insulator layer;
a pair of epitaxial source or drain structures at first and second ends of the vertical arrangement of horizontal semiconductor nanowires and on the insulator layer; and
a gate stack surrounding a channel region of the vertical arrangement of horizontal semiconductor nanowires, the gate stack comprising a high-k dielectric layer continuous with and having a same composition as the insulator layer.

2. The integrated circuit structure of claim 1, wherein each of the pair of epitaxial source or drain structures has a compressed lattice.

3. The integrated circuit structure of claim 1, wherein each of the pair of epitaxial source or drain structures has an expanded lattice.

4. The integrated circuit structure of claim 1, 2 or 3, wherein the insulator layer is on a sub-fin, the sub-fin above or on the substrate.

5. The integrated circuit structure of claim 1, 2, 3 or 4, wherein the vertical arrangement of horizontal semiconductor nanowires comprises silicon.

6. The integrated circuit structure of claim 1, 2, 3, 4 or 5, wherein the pair of epitaxial source or drain structures is a pair of non-discrete epitaxial source or drain structures.

7. The integrated circuit structure of claim 1, 2, 3, 4, 5 or 6, wherein the gate stack comprises a metal gate electrode.

8. The integrated circuit structure of claim 1, 2, 3, 4, 5, 6 or 7, wherein the semiconductor material of the pair of epitaxial source or drain structures is silicon.

9. The integrated circuit structure of claim 1, 2, 3, 4, 5, 6 or 7, wherein the semiconductor material of the pair of epitaxial source or drain structures is silicon germanium.

10. A method of fabricating an integrated circuit structure, the method comprising:
forming an insulator layer above a substrate;
forming a vertical arrangement of horizontal semiconductor nanowires over the insulator layer;
forming a pair of epitaxial source or drain structures at first and second ends of the vertical arrangement of horizontal semiconductor nanowires and on the insulator layer; and
forming a gate stack surrounding a channel region of the vertical arrangement of horizontal semiconductor nanowires, the gate stack comprising a high-k dielectric layer continuous with and having a same composition as the insulator layer.

11. The method of claim 10, wherein each of the pair of epitaxial source or drain structures has a compressed lattice.

12. The method of claim 10, wherein each of the pair of epitaxial source or drain structures has an expanded lattice.

13. The method of claim 10, 11 or 12, wherein the insulator layer is on a sub-fin, the sub-fin above or on the substrate.

14. The method of claim 10, 11, 12 or 13, wherein the vertical arrangement of horizontal semiconductor nanowires comprises silicon.

15. The method of claim 10, 11, 12, 13 or 14, wherein the pair of epitaxial source or drain structures is a pair of non-discrete epitaxial source or drain structures.
